# EUROPEAN PATENT SPECIFICATION

(11) **EP 4 498 603 B1**
(45) Date of publication and mention of the grant of the patent: **07.10.2026**
(21) Application number: 24188643.1
(22) Date of filing: 15.07.2024
(51) Int. Cl.: H03K 17/18, H02M 3/335, H03K 17/61, H03K 17/691

(54) **DATA COMMUNICATION FOR GALVANIC ISOLATED DC-DC CONVERTER ON FULLY INTEGRATED ARCHITECTURE WITH CORELESS TRANSFORMER**
DATENKOMMUNIKATION FÜR GALVANISCH ISOLIERTEN GLEICHSPANNUNGSWANDLER IN VOLLINTEGRIERTER ARCHITEKTUR MIT KERNLOSEM TRANSFORMATOR
COMMUNICATION DE DONNÉES POUR CONVERTISSEUR CC-CC ISOLÉ GALVANIQUEMENT SUR UNE ARCHITECTURE ENTIÈREMENT INTÉGRÉE AVEC TRANSFORMATEUR SANS NOYAU

(30) Priority: 25.07.2023 US 202318225955
(43) Date of publication of application: 29.01.2025
(73) Proprietor: STMicroelectronics International N.V., 1228 Plan-les-Ouates, Geneva (CH)
(72) Inventor: PERROTTA, Stefano, I-95030 Nicolosi (Catania) (IT); PRIVITERA, Salvatore Giuseppe, I-95047 Paternò (Catania) (IT); PULVIRENTI, Francesco, I-95024 Acireale (Catania) (IT)
(74) Representative: Buzzi, Notaro & Antonielli d'Oulx S.p.A.

(56) References cited:
- EP-A1- 3 624 317
- US-A1- 2019 305 775
- RAGONESE EGIDIO ET AL: "A Fully Integrated Galvanically Isolated DC-DC Converter With Data Communication", IEEE TRANSACTIONS ON CIRCUITS AND SYSTEMS I: REGULAR PAPERS, IEEE, US, vol. 65, no. 4, 1 April 2018 (2018-04-01), pages 1432 - 1441, XP011678911, ISSN: 1549-8328, [retrieved on 20180309], DOI: 10.1109/TCSI.2017.2742021

## Description

### TECHNICAL FIELD

This disclosure is directed to the field of power transmission across a galvanic isolation and, in particular, to a DC-DC converter for transmitting power across a galvanic isolation while transmitting feedback data back across the galvanic isolation without using an additional communication channel.

### BACKGROUND

Current market trends are pushing for integrated solutions in various applications, with DC-DC converters of power less than 1W being no exception. The driving factors behind this shift include the desire for compactness, cost-effectiveness, and high efficiency. A feature in these converters is galvanic isolation, which aids in isolating electrical systems from each other, reduces the risk of current leakage, and helps prevent electrical faults from damaging the load.

Fully integrated converters that incorporate coreless transformers are now known. These transformers transmit power across a galvanic isolation, offering the advantage of reduction of the size of the system compared to traditional transformers.

Nevertheless, these converters face a persistent challenge in managing the feedback signal, utilized for output voltage regulation, and maintaining high conversion efficiency. The feedback signal allows for adjustments in the driving of the transformer based on the output voltage, thereby optimizing power conversion. Known circuits transmit this feedback signal through dedicated channels on the Printed Circuit Board (PCB) or internally within the System in Package (SiP), but these methods can lead to an increase in size, cost, and could potentially compromise efficiency.

Many of the existing designs for galvanic isolation use separate physical channels for power and signal transmission. These designs often require multiple components, which increases complexity, space requirements, and potentially undermines conversion efficiency. Moreover, using separate channels for power and signal transmission can result in increased electromagnetic interference, adding further complications to the design and operation of the converters.

Document US 2019/305775 A1 discloses an oscillator coupled to a first side of a galvanic barrier for supplying thereto an electric supply signal. The oscillator is configured to be alternatively turned on and off as a function of a PWM drive signal applied thereto. A receiver circuit coupled to the galvanic barrier receives therefrom a PWM power control signal. A signal reconstruction circuit coupled between the receiver circuit block and the oscillator provides to the oscillator a PWM drive signal reconstructed from the PWM power control signal. The signal reconstruction circuit includes a PLL circuit coupled to the receiver circuit block and configured to lock to the PWM control signal from the receiver circuit block. A PLL loop within the PLL circuit is sensitive to the PWM drive signal applied to the oscillator. The PLL loop is configured to be opened as a result of the power supply oscillator being turned off.

Document EP 3 624 317 A1 discloses a control device for controlling a power semiconductor device that comprises a primary side control unit for receiving a control signal from a superordinated controller and for generating a binary primary side switching signal for the power semiconductor device as well as a secondary side control unit for generating a gate signal for the power semiconductor device plus a transformer for transferring electrical energy from the primary side control unit to the secondary side control unit and for transferring the primary side switching signal from the primary side control unit to the secondary side control unit. The primary side control unit comprises a voltage modulation unit for modulating an input voltage of the transformer, such that the primary side switching signal is encoded into the input voltage. The input voltage is a signal sequence comprising rising edges encoding a first value of the primary side switching signal and falling edges encoding a second value of the primary side switching signal. The secondary side control unit comprises a power supply unit for generating electrical power from an output voltage of the transformer for supplying the secondary side control unit. The secondary side control unit comprises a voltage decoder unit for extracting a secondary side switching signal from the output voltage by detecting the rising edges and the falling edges in the output voltage and for generating the gate signal from the secondary side switching signal.

Background information on the related art can be gathered from E. Ragonese et al.: "A Fully Integrated Galvanically Isolated DC-DC Converter With Data Communication", in IEEE Transactions on Circuits and Systems I: Regular Papers, vol. 65, no. 4, pp. 1432-1441, April 2018.

Given these issues, further development is required to offer solutions that provide for efficient management of the feedback signal.

### SUMMARY

The invention relates to a device incorporating a DC-DC converter as claimed in claim 1

Advantageous features of such a device are recited in subclaims 2 to 9.

### BRIEF DESCRIPTION OF THE DRAWINGS

FIG. 1 is a block diagram of a DC-DC converter disclosed herein.
FIG. 2 is a schematic diagram of the receiver demodulator of the DC-DC converter of FIG. 1.
FIG. 3 includes graphs showing the voltages at nodes P0 and P1 and the filtered versions VC0 and VC1 of those voltages.
FIG. 4 is a graph showing the envelope of the voltages VC0 and VC1 generated by the envelope detector of FIG. 2.
FIG. 5 is a graph showing the envelope of voltages VCO and VC1 generated by the envelope detector of FIG. 2 as compared to the V+ and V- voltages.
FIG. 6 is a timing diagram showing operation of the DC-DC converter of FIG. 1 in an open loop configuration.
FIG. 7 is a timing diagram showing operation of the DC-DC converter of FIG. 1 in a closed loop configuration.
FIG. 8 is a block diagram of a fully isolated DC-DC supply converter circuit formed using the DC-DC converter of FIG. 1.
FIG. 9 is a block diagram of a power supply circuit formed using the DC-DC converter of FIG. 1.

### DETAILED DESCRIPTION

The following disclosure enables a person skilled in the art to make and use the subject matter described herein. The general principles outlined in this disclosure can be applied to embodiments and applications other than those detailed above without departing from the extent of protection as determined by the claims.

Note that in the following description, any resistor or resistance mentioned is a discrete device, unless stated otherwise, and is not simply an electrical lead between two points. Therefore, any resistor or resistance connected between two points has a higher resistance than a lead between those two points, and such resistor or resistance cannot be interpreted as a lead. Similarly, any capacitor or capacitance mentioned is a discrete device, unless stated otherwise, and is not a parasitic element, unless stated otherwise. Additionally, any inductor or inductance mentioned is a discrete device, unless stated otherwise, and is not a parasitic element, unless stated otherwise.

In general, this disclosure is directed to the technical field of power conversion and transmission, and to a circuit for efficient direct current to direct current (DC-DC) conversion across a galvanic isolation barrier. Described herein is therefore a DC-DC converter utilizing a coreless transformer that not only transmits power from a primary side circuit to a secondary side circuit but also enables the transmission of feedback signals from the secondary side to the primary side via Amplitude Shift Keying (ASK) modulation without utilizing an additional communication channel, thus reducing area consumption.

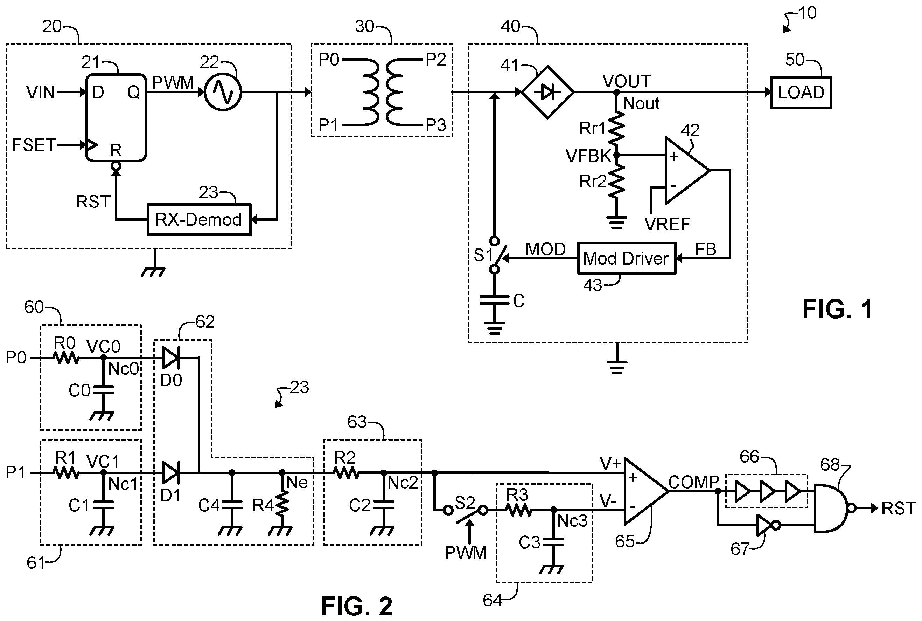

Now described with reference to FIG. 1 is a DC-DC converter 10, which includes a coreless transformer 30. In general, operation of the DC-DC converter 10 proceeds with a primary side circuit 20 (e.g., first integrated circuit) transmitting power to a secondary side circuit 40 (e.g., second integrated circuit) using the transformer 30, and with the secondary side circuit 40 transmitting a feedback signal to the primary side circuit 20 using the transformer 30 via Amplitude Shift Keying (ASK) so that the primary side circuit 20 may modify its driving of the transformer 30 based upon the feedback signal.

In detail, the primary side circuit 20 includes a flip flop 21 that has a data input D connected to an input voltage VIN, a clock input connected to receive a set signal Fset, a reset input R connected to receive a reset signal RST, and an output Q at which a pulse width modulation (PWM) signal is generated. The frequency of the set signal Fset is dependent on loop stability and load capacitance. For example, with a load capacitance of 20 µF, the frequency of the set signal Fset may be 20 kHz. An oscillator 22 drives the primary side of the transformer 30 based upon the PWM signal (e.g., is turned on or off by the PWM signal).

The secondary side circuit 40 is galvanically isolated from the primary side circuit 20 by the transformer 30 and includes a rectifier 41 that rectifies the power produced from the secondary side of the transformer 30 when the primary side of the transformer 30 is driven to thereby generate a rectified output voltage VOUT at an output node Nout. A load 50 is connected to the output node Nout to receive the output voltage VOUT.

When the set signal Fset is asserted to clock the flip flop 21 and the input voltage VIN is at a logic high, the flip flop 21 asserts the PWM signal, causing the oscillator 22 to generate an oscillating signal driving the primary side of the transformer 30 to transmit power to the secondary side of the transformer 30, causing the output voltage VOUT to begin ramping upwardly. The frequency of the oscillating signal that the primary side of the transformer 30 is driven by is set by the design of the oscillator 22 itself, but the duty cycle of the oscillating signal output by the oscillator 22 is set by the reset signal RST as will be described below.

A voltage divider is formed by resistors Rr1 and Rr2 series connected between the output node Nout and ground, with a feedback voltage VFBK therefore being formed at a tap between the resistors Rr1 and Rr2. A comparator 42 receives the feedback voltage VFBK at its non-inverting input terminal and a reference voltage VREF at its inverting input terminal, and asserts a feedback signal FB when the feedback voltage VFBK (representative of the output voltage VOUT) is greater than or equal to the reference voltage VREF, but otherwise deasserts the feedback signal FB.

A modulator driver 43 receives the feedback signal FB as input. When the feedback signal FB is asserted, it closes and opens simultaneously the first switch S1, which is connected between the input of the rectifier 41 and a capacitor C. If the feedback signal FB is not asserted, the first switch S1 remains open.

Closing the first switch S1 to connect the capacitor C between the input of the rectifier 41 and ground has the effect of reducing the voltage across the primary side of the transformer 30 by an amount proportional to the capacitance of the capacitor C (e.g., modulating the amplitude of the voltage across the primary side of the transformer 30 to perform amplitude shift keying modulation). This modulation is repeatedly performed by the modulator driver 43 at a frequency dependent on the frequency of the carrier - for example, with the frequency of driving of the primary of the transformer 30 being at 20 MHz and the modulator driver 43 driving the switch S1 at a frequency of 800 kHz. In general, the following mathematical relationship between the modulation frequency used by the modulator driver 43 and the carrier frequency is followed: ${F}_{modulating} = \frac{{F}_{carrier}}{20}$

This relationship is set such that *F_{carrier}* and *F_{modulating}* are sufficiently far apart to facilitate carrier filtration during demodulation.

A receiver demodulator 23 in the primary side circuit 20 monitors the voltage across the primary side of the transformer 30 and asserts the reset signal RST to thereby cause deassertion of the PWM signal by the flip flop 21 in response to the modulation of the voltage across the primary side of the transformer 30 indicating that the feedback signal FB has been asserted, thereby ceasing upward ramping of the output voltage VOUT.

Further details will be given with reference to FIG. 2, showing the details of the receiver demodulator 23. The primary side of the transformer 30 is connected between nodes P0 and P1. A first RC filter 60 is connected between node P0 and node Nc0. The first RC filter 60 includes a resistor R0 connected between node P0 and node Nc0 and a capacitor C0 connected between node Nc0 and ground, with a first filtered voltage VC0 being formed across capacitor C0 dependent on the voltage at node P0. A second RC filter 61 is connected between node P1 and node Nc1. The second RC filter 61 includes a resistor R1 connected between node P1 and node Nc1 and a capacitor C1 connected between node Nc1 and ground, with a second filtered voltage VC1 being formed across capacitor C1 dependent on the voltage formed at node P1.

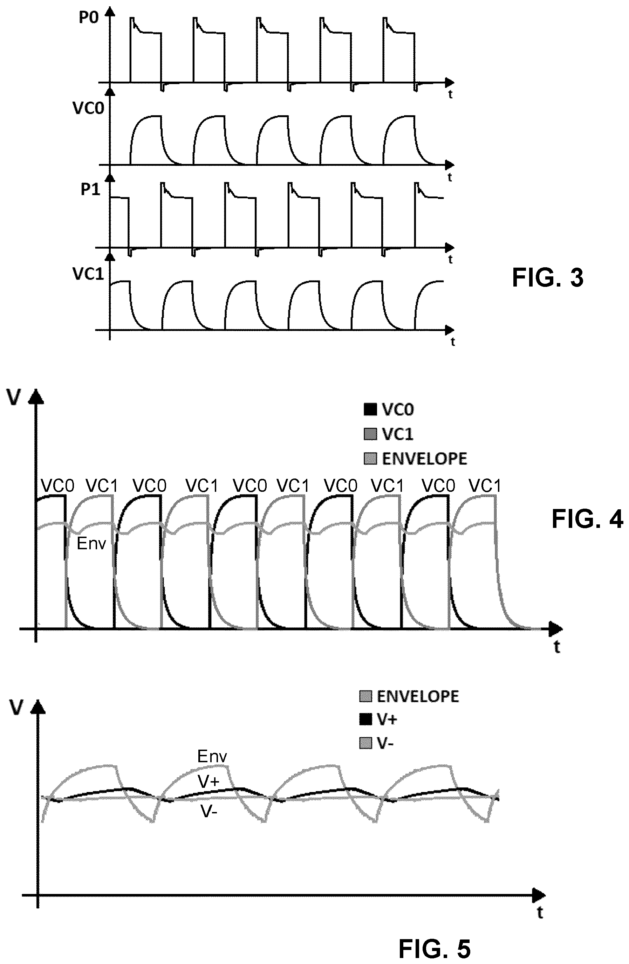

Refer to FIG. 3, where the effect of the RC filter 60 upon the voltage at P0 to produce the filtered voltage VC0, and the effect of the RC filter 61 upon the voltage at P1 (which is 180° out of phase with the voltage V0) to produce the filtered voltage VC1, can be observed.

An envelope detector 62 is connected between nodes Nc0/Nc1 and Ne. In particular, the envelope detector 62 includes diode D0 having its anode connected to node Nc0 and its cathode connected to node Ne, diode D1 having its anode connected to node Nc1 and its cathode connected to node Ne, capacitor C4 connected between node Ne and ground, and resistor R4 connected between node Ne and ground.

The output of the envelope detector 62 at node Ne is the envelope of the voltages VC0 and VC1, as shown in FIG. 4. In greater detail, envelope is a signal charged to the peak value of VC0 or VC1 less the drop across the diode D0 or D1.

A third RC filter 63 is connected between node Ne and Nc2. The third RC filter 63 includes a resistor R2 connected between nodes Ne and Nc2 and a capacitor C2 connected between node Nc2 and ground, with a third filtered voltage V+ being formed across the capacitor C2. A fourth RC filter 64 is switchingly connected between nodes Nc2 and Nc3 by switch S2 which is operated by the PWM signal, and together with S2 forms a sample/hold circuit. The fourth RC filter 64 includes a resistor R3 connected between switch S2 and node Nc3 and a capacitor C3 connected between node Nc3 and ground, with a fourth filtered voltage V- being formed across capacitor C3. The time constant T3 of the fourth RC filter 64 is greater than the time constant T2 of the third RC filter 63, for example T3 being 100x T2.

A comparator 65 has its non-inverting input coupled to node Nc2 to receive voltage V+ (the envelope after filtering by RC filter 63) and its inverting input coupled to node Nc3 to receive voltage V- (the average of V+, produced by RC filter 64). The voltage V+ and the voltage V- (when switch S2 is closed) are shown as compared to the envelope produced by envelope detector 62 in FIG. 5.

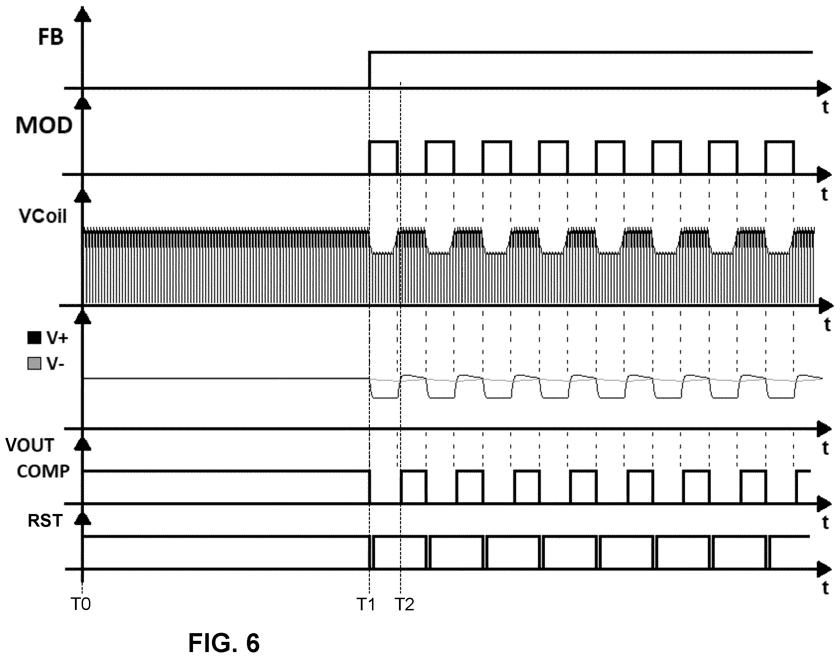

The operation of the receiver demodulator 23 will be given. First, however, refer to FIG. 6, showing, between times T0 and T1, a hypothetical open-loop operating case where the DC-DC converter 10 is operating at a steady state where the oscillator 22 is driving the transformer 30, but the reset signal RST is ignored by the flip flop 21. Observe that the output COMP of the comparator 65 remains a logic high between times T0 and T1 because the voltages V+ and V- are generally equal. At time T1, the feedback voltage VFBK becomes greater than the reference voltage VREF, and the feedback signal FB is correspondingly asserted by the comparator 42. As a result of this, the modulator driver 43 asserts the MOD signal, closing switch S1, causing a modulation (lowering) of the voltage Vcoil across the transformer 30 between times T1 and T2. As a result of this, the voltage V+ becomes less than the voltage V-, causing the output COMP of the comparator 65 to briefly transition to a logic low. The delay line 66, inverter 67, and NAND gate 68 form a pulse generator acting on the falling edge of the COMP signal.

In this hypothetical operating instance, as stated, the flip flop 21 ignores the reset signal RST, so the output voltage VOUT is not altered.

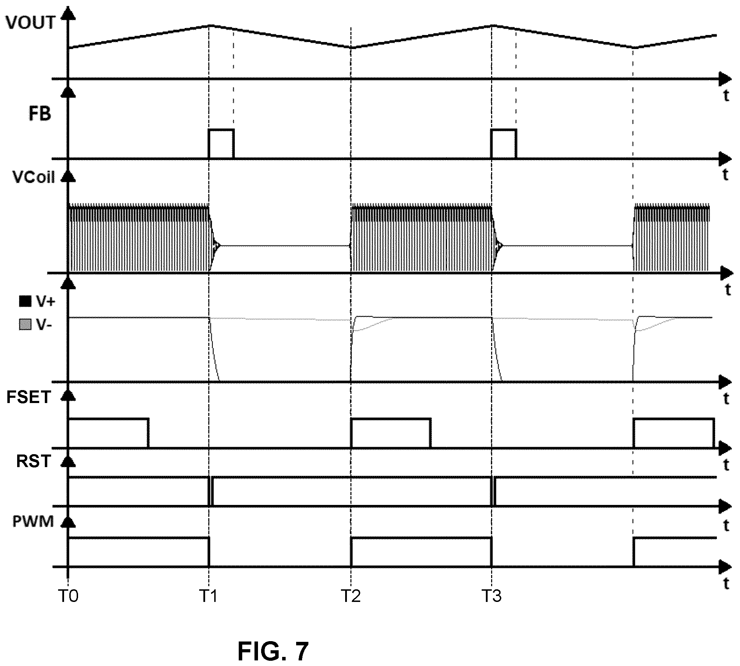

Turn now to FIG. 7, illustrating a standard operating mode in which the reset signal RST is not ignored. Observe between times T0 and T1 where the oscillator 22 is driving the transformer 30, and as a result, the output voltage VOUT ramps upwardly. At time T1 the feedback voltage VFBK becomes greater than the reference voltage VREF, and the feedback signal FB is correspondingly asserted by the comparator 42. As a result of this, the modulator driver 43 asserts the MOD signal, closing switch S1, causing a modulation (lowering) of the voltage Vcoil across the transformer 30 at time T1.

As a result of this drop in Vcoil at time T1, the voltage V+ at the non-inverting input terminal of the comparator 65 falls substantially below the voltage V- at the inverting input terminal of the comparator 65. This correspondingly results in the reset signal RST at the output of the NAND gate 68 transitioning to a logic low at time T1, resetting the flip flop 21, causing the PWM signal to transition low. The PWM signal transitioning low opens switch S2, with the voltage V- being maintained by the capacitor C3 while the voltage V+ drops. As another result of the PWM signal transitioning low, the oscillator 22 stops driving the transformer 30, and the output voltage VOUT begins to ramp downwardly between times T1 and T2.

When the next pulse of FSET arrives at time T2, the flip flop 21 reasserts the PWM signal, closing switch S2, causing the oscillator 22 to again drive the transformer 30, causing the output voltage VOUT to ramp upwardly again and operation between times T2 and T3 proceeds as with operation between time T0 and T1. Note that upon restart at time T2 due to arrival of the next pulse of FSET, the voltage V+ will exceed V- (since the instantaneous value of V+ can rise at a quicker rate than its average), causing the comparator 65 to assert its output COMP; this is a necessary condition because the logic of the RST signal works on the falling edge of the comparison output COMP - this condition likewise occurs at startup.

As can be appreciated, due to power transfer at a fixed frequency, this DC-DC converter 10 provides for high efficiency power transfer across a galvanic isolation. In addition, due to the use of ASK for providing the feedback, which is demodulated by the specifically designed receiver demodulator 23, little additional area is consumed to provide for the feedback channel back across the galvanic isolation. Still further, the comparison of the envelope with its own average makes the design robust against variations due to process spread, temperature variation, etc.

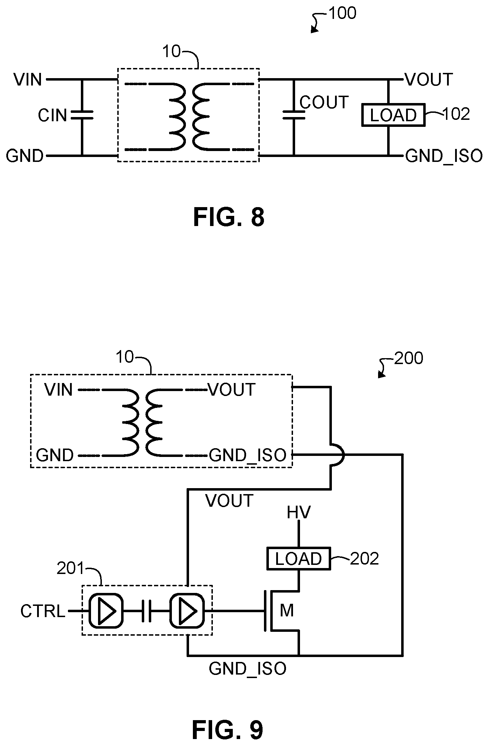

The DC-DC converter 10 may be used in a variety of applications. For example, as shown in FIG. 8, the DC-DC converter 10 may be used in an isolated DC-DC supply converter circuit 100, where the DC-DC converter 100 receives the input voltage VIN formed across a capacitor CIN coupled between the input and a first ground GND, and provides the output voltage VOUT across a capacitor COUT coupled between the output and a second ground GND_ISO that is isolated form the first ground GND.

Likewise, the DC-DC converter 10 may be used as a power supply for gate driver 201 as shown in FIG. 9. Here, a power transistor M is coupled between a load 202 and the isolated ground GND_ISO to thereby sink power from a high voltage node HV through the load 202. The power transistor M has its gate terminal driven by the gate driver circuit 201, which receives a control signal CTRL as input. The gate driver circuit 201 is powered between the output voltage VOUT generated by the DC-DC converter and the isolated ground GND_ISO.

Finally, it is evident that modifications and variations can be made to what has been described and illustrated herein without departing from the scope of this disclosure.

The invention is defined by the features of the independent claim. Preferred embodiments are set out in the dependent claims.

## Claims

1. A device comprising a DC-DC converter (10), wherein the DC-DC converter (10) comprises:
a transformer (30) having a primary coil and a secondary coil;
a primary-side control circuit (20) comprising:
an oscillator (22) configured to drive the transformer (30) in response to assertion of a pulse width modulation, PWM signal to thereby transmit power from the primary to the secondary, and to cease driving the transformer (30) in response to deassertion of the PWM signal;
a receiver demodulator circuit (23) configured to receive and demodulate a feedback signal sent from the secondary to the primary by comparing an instantaneous value of an envelope indicative of voltages at the primary coil to an average value of the envelope to thereby produce a reset signal (RST); and
a PWM circuit (21) configured to assert the PWM signal in response to a set signal (FSET) and deassert the PWM signal in response to assertion of the reset signal (RST); and
a secondary-side control circuit (40) configured to:
transmit said feedback signal from the secondary-side control circuit (40) to the primary-side control circuit (20) via Amplitude Shift Keying, ASK;
rectify the power received at the secondary to generate an output voltage (VOUT);
assert an intermediate feedback signal (FB) if a feedback voltage (VFBK) indicative of the output voltage (VOUT) is greater than or equal to a reference voltage (VREF); and
connect a capacitance (C) between the secondary and the ground in response to assertion of the intermediate feedback signal (FB) to thereby reduce the voltage across the primary side of the transformer (30) and modulate the amplitude of the ASK feedback signal sent from the secondary side to the primary side;
wherein the receiver demodulator circuit (23) comprises:
an envelope detector (62) configured to generate the envelope indicative of the voltages at the primary coil;
a comparator (65) configured to compare an instantaneous value of the envelope to an average of the envelope; and
a combinatorial logic circuit (66, 67, 68) configured to generate the reset signal (RST) based upon output from the comparator (65).

2. The device of claim 1, wherein the PWM circuit comprises a flip flop (21) having a data input (D) coupled to receive an input voltage (VIN), a clock input coupled to receive the set signal (FSET), a reset input (R) coupled to receive the reset signal (RST), and an output (Q) at which the PWM signal is generated.

3. The device of claim 1,
wherein the comparator (65) includes a first input coupled to receive the instantaneous value of the envelope, a second input coupled to receive the average of the envelope, and an output coupled to the combinatorial logic circuit (66, 67, 68); and
wherein the receiver demodulator circuit (23) further comprises an averaging circuit configured to generate the average of the envelope, the averaging circuit comprising: a capacitor (C3) coupled to the second input of the comparator (65); a switch (S2) configured to couple the envelope to the second input of the comparator (65) in response to assertion of the PWM signal and decouple the envelope from the second input of the comparator (65) in response to desertion of the PWM signal.

4. The device of claim 3, wherein the receiver demodulator circuit (23) further comprises:
a first filter (60) coupled between a first terminal (P0) of the primary coil and a first input of the envelope detector (62); and
a second filter (61) coupled between a second terminal (P1) of the primary coil and a second input of the envelope detector (62).

5. The device of claim 4, wherein the receiver demodulator circuit (23) further comprises a third filter (63) coupled between the envelope detector (62) and the first input of the comparator (65).

6. The device of claim 5, wherein the receiver demodulator circuit (23) further comprises a resistor (R3) coupled between the switch (S2) and the second input of the comparator (65).

7. The device of claim 6, wherein the combinatorial logic circuit comprises:
a delay circuit (66) configured to delay the output of the comparator (65);
an inverter (67) configured to invert the output of the comparator (65); and
a NAND gate (68) configured to perform a logic NAND operation on the delayed output of the comparator (65) and the inverted output of the comparator (65) to thereby generate the reset signal (RST).

8. The device of claim 1, wherein the secondary-side control circuit (40) comprises:
a rectifier (41) configured to rectify the power received at the secondary to generate an output voltage (VOUT) at an output node (Nout);
a resistor divider (Rr1, Rr2) coupled between the output node (Nout) and ground, with the feedback voltage (VFBK) being generated at a tap of the resistor divider;
a comparator (42) configured to assert an intermediate feedback signal (FB) if the feedback voltage (VFBK) is greater than or equal to the reference voltage (VREF);
a driver (43) configured to assert a control signal (MOD) in response to assertion of the intermediate feedback signal (FB); and
a switch (S1) configured to connect said capacitance (C) between the secondary coil and the ground in response to assertion of the control signal (MOD) to thereby modulate and send the ASK feedback signal from the secondary to the primary.

9. The device of claim 1, wherein the DC-DC converter (10) is configured to be used to power a gate driver (201) that generates a gate drive signal for a gate of a power transistor (M) that powers a load (202).

## Patentansprüche

1. Vorrichtung, die einen DC-DC-Wandler (10) umfasst, wobei der DC-DC-Wandler (10) umfasst:
einen Transformator (30) mit einer Primärspule und einer Sekundärspule;
eine primärseitige Steuerschaltung (20), umfassend:
einen Oszillator (22), der so eingerichtet ist, dass er den Transformator (30) als Reaktion auf die Aktivierung eines Pulsweitenmodulations, PWM,-Signals ansteuert, um dadurch Leistung von der Primärseite zur Sekundärseite zu übertragen, und das Ansteuern des Transformators (30) als Reaktion auf die Deaktivierung des PWM-Signals beendet;
eine Empfänger-Demodulatorschaltung (23), die so eingerichtet ist, dass sie ein von der Sekundärseite zur Primärseite gesendetes Rückmeldesignal empfängt und demoduliert, indem sie einen Momentanwert einer Hülle, der Spannungen an der Primärspule angibt, mit einem Durchschnittswert der Hülle vergleicht, um dadurch ein Rücksetzsignal (RST) zu erzeugen; und
eine PWM-Schaltung (21), die so eingerichtet ist, dass sie das PWM-Signal als Reaktion auf ein Setzsignal (FSET) aktiviert und das PWM-Signal als Reaktion auf das Aktivieren des Rücksetzsignals (RST) deaktiviert; und
eine sekundärseitige Steuerschaltung (40), die für Folgendes eingerichtet ist:
Übertragen des Rückmeldesignals von der sekundärseitigen Steuerschaltung (40) an die primärseitige Steuerschaltung (20) über Amplitudenumtastung, ASK;
Gleichrichten der an der Sekundärseite empfangenen Leistung, um eine Ausgangsspannung (VOUT) zu generieren;
Aktivieren eines Zwischenrückmeldesignals (FB), wenn eine Rückmeldespannung (VFBK), die die Ausgangsspannung (VOUT) angibt, größer oder gleich einer Referenzspannung (VREF) ist; und
Anschließen einer Kapazität (C) zwischen der Sekundärseite und der Masse als Reaktion auf die Aktivierung des Zwischenrückmeldesignals (FB), um dadurch die Spannung über die Primärseite des Transformators (30) zu reduzieren und die Amplitude des von der Sekundärseite zur Primärseite gesendeten ASK-Rückmeldesignals zu modulieren;
wobei die Empfänger-Demodulatorschaltung (23) umfasst:
einen Hüllkurvendetektor (62), der so eingerichtet ist, dass er die Hüllkurve generiert, die die Spannungen an der Primärspule angibt;
einen Komparator (65), der so eingerichtet ist, dass er einen Momentanwert der Hülle mit einem Durchschnitt der Hülle vergleicht; und
eine kombinatorische Logikschaltung (66, 67, 68), die so eingerichtet ist, dass sie das Rücksetzsignal (RST) basierend auf dem Ausgang vom Komparator (65) generiert.

2. Vorrichtung nach Anspruch 1, wobei die PWM-Schaltung ein Flip-Flop (21) umfasst, das einen Dateneingang (D), der zum Empfangen einer Eingangsspannung (VIN) gekoppelt ist, einen Takteingang, der zum Empfangen des Setzsignals (FSET) gekoppelt ist, einen Rücksetzeingang (R), der zum Empfangen des Rücksetzsignals (RST) gekoppelt ist, und einen Ausgang (Q) aufweist, an dem das PWM-Signal generiert wird.

3. Vorrichtung nach Anspruch 1,
wobei der Komparator (65) einen ersten Eingang, der zum Empfangen des Momentanwerts der Hülle gekoppelt ist, einen zweiten Eingang, der zum Empfangen des Durchschnitts der Hülle gekoppelt ist, und einen Ausgang enthält, der mit der kombinatorischen Logikschaltung (66, 67, 68) gekoppelt ist; und
wobei die Empfänger-Demodulatorschaltung (23) ferner eine Mittelungsschaltung umfasst, die so eingerichtet ist, dass sie den Mittelwert der Hülle generiert, wobei die Mittelungsschaltung umfasst: einen Kondensator (C3), der mit dem zweiten Eingang des Komparators (65) gekoppelt ist; einen Schalter (S2), der so eingerichtet ist, dass er die Hülle als Reaktion auf die Aktivierung des PWM-Signals mit dem zweiten Eingang des Komparators (65) koppelt und die Hülle als Reaktion auf die Deaktivierung des PWM-Signals von dem zweiten Eingang des Komparators (65) entkoppelt.

4. Vorrichtung nach Anspruch 3, wobei die Empfänger-Demodulatorschaltung (23) ferner umfasst:
einen ersten Filter (60), der zwischen einem ersten Anschluss (P0) der Primärspule und einem ersten Eingang des Hüllkurvendetektors (62) gekoppelt ist; und
einen zweiten Filter (61), der zwischen einem zweiten Anschluss (P1) der Primärspule und einem zweiten Eingang des Hüllkurvendetektors (62) gekoppelt ist.

5. Vorrichtung nach Anspruch 4, wobei die Empfänger-Demodulatorschaltung (23) ferner einen dritten Filter (63) umfasst, der zwischen dem Hüllkurvendetektor (62) und dem ersten Eingang des Komparators (65) gekoppelt ist.

6. Vorrichtung nach Anspruch 5, wobei die Empfänger-Demodulatorschaltung (23) ferner einen Widerstand (R3) umfasst, der zwischen dem Schalter (S2) und dem zweiten Eingang des Komparators (65) gekoppelt ist.

7. Vorrichtung nach Anspruch 6, wobei die kombinatorische Logikschaltung umfasst:
eine Verzögerungsschaltung (66), die so eingerichtet ist, dass sie den Ausgang des Komparators (65) verzögert;
einen Wechselrichter (67), der so eingerichtet ist, dass er den Ausgang des Komparators (65) invertiert; und
ein NAND-Gate (68), das so eingerichtet ist, dass es eine logische NAND-Verknüpfung am verzögerten Ausgang des Komparators (65) und dem invertierten Ausgang des Komparators (65) durchführt, um dadurch das Rücksetzsignal (RST) zu generieren.

8. Vorrichtung nach Anspruch 1, wobei die sekundärseitige Steuerschaltung (40) umfasst:
einen Gleichrichter (41), der so eingerichtet ist, dass er die an der Sekundärseite empfangene Leistung gleichrichtet, um eine Ausgangsspannung (VOUT) an einem Ausgangsknoten (Nout) zu generieren;
einen Widerstandsteiler (Rr1, Rr2), der zwischen dem Ausgangsknoten (Nout) und der Masse gekoppelt ist, wobei die Rückmeldespannung (VFBK) an einem Abgriff des Widerstandsteilers erzeugt wird;
einen Komparator (42), der so eingerichtet ist, dass er ein Zwischenrückmeldesignal (FB) aktiviert, wenn die Rückmeldespannung (VFBK) größer oder gleich der Referenzspannung (VREF) ist;
einen Treiber (43), der so eingerichtet ist, dass er ein Steuersignal (MOD) als Reaktion auf die Aktivierung des Zwischenrückmeldesignals (FB) aktiviert; und
einen Schalter (S1), der so eingerichtet ist, dass er die Kapazität (C) zwischen der Sekundärspule und der Masse als Reaktion auf die Aktivierung des Steuersignals (MOD) anschließt, um dadurch das ASK-Rückmeldungssignal zu modulieren und von der Sekundärseite zur Primärseite zu senden.

9. Vorrichtung nach Anspruch 1, wobei der DC-DC-Wandler (10) so eingerichtet ist, dass er verwendet werden kann, um einen Gate-Treiber (201) zu speisen, der ein Gate-Treibersignal für ein Gate eines Leistungstransistors (M) generiert, der eine Last (202) speist.

## Revendications

1. Dispositif comprenant un convertisseur continu-continu (10), dans lequel le convertisseur continu-continu (10) comprend :
un transformateur (30) ayant une bobine primaire et une bobine secondaire ;
un circuit de commande côté primaire (20) comprenant :
un oscillateur (22) configuré pour exciter le transformateur (30) en réponse à l'activation d'un signal de modulation d'impulsions en largeur, MIL, pour transmettre ainsi de l'énergie du primaire au secondaire, et pour cesser d'exciter le transformateur (30) en réponse à la désactivation du signal MIL ;
un circuit démodulateur récepteur (23) configuré pour recevoir et démoduler un signal de rétroaction envoyé du secondaire au primaire en comparant une valeur instantanée d'une enveloppe représentant des tensions électriques au niveau de la bobine primaire avec une valeur moyenne de l'enveloppe pour produire ainsi un signal de réinitialisation (RST) ; et
un circuit MIL (21) configuré pour activer le signal MIL en réponse à un signal d'établissement (FSET) et pour désactiver le signal MIL en réponse à l'activation du signal de réinitialisation (RST) ; et
un circuit de commande côté secondaire (40) configuré pour :
transmettre ledit signal de rétroaction du circuit de commande côté secondaire (40) au circuit de commande côté primaire (20) au moyen d'une modulation par déplacement d'amplitude, ASK ;
redresser l'énergie reçue au secondaire pour produire une tension de sortie (VOUT) ;
activer un signal de rétroaction intermédiaire (FB) si une tension de rétroaction (VFBK) représentant la tension de sortie (VOUT) est supérieure ou égale à une tension de référence (VREF) ; et
connecter une capacité (C) entre le secondaire et la masse en réponse à l'activation du signal de rétroaction intermédiaire (FB) pour réduire ainsi la tension aux bornes du côté primaire du transformateur (30) et moduler l'amplitude du signal de rétroaction ASK envoyé du côté secondaire au côté primaire ;
dans lequel le circuit démodulateur récepteur (23) comprend :
un détecteur d'enveloppe (62) configuré pour générer l'enveloppe représentant les tensions au niveau de la bobine primaire ;
un comparateur (65) configuré pour comparer une valeur instantanée de l'enveloppe avec une moyenne de l'enveloppe ; et
un circuit de logique combinatoire (66, 67, 68) configuré pour produire le signal de réinitialisation (RST) en fonction de la sortie du comparateur (65).

2. Dispositif selon la revendication 1, dans lequel le circuit MIL comprend une bascule (21) ayant une entrée de données (D) couplée pour recevoir une tension d'entrée (VIN), une entrée d'horloge couplée pour recevoir le signal d'établissement (FSET), une entrée de réinitialisation (R) couplée pour recevoir le signal de réinitialisation (RST), et une sortie (Q) sur laquelle est produit le signal MIL.

3. Dispositif selon la revendication 1,
dans lequel le comparateur (65) comprend une première entrée couplée pour recevoir la valeur instantanée de l'enveloppe, une deuxième entrée couplée pour recevoir la moyenne de l'enveloppe, et une sortie couplée au circuit de logique combinatoire (66, 67, 68) ; et
dans lequel le circuit démodulateur récepteur (23) comprend en outre un circuit de moyenne configuré pour produire la moyenne de l'enveloppe, le circuit de moyenne comprenant : un condensateur (C3) couplé à la deuxième entrée du comparateur (65) ; un interrupteur (S2) configuré pour coupler l'enveloppe à la deuxième entrée du comparateur (65) en réponse à l'activation du signal MIL et pour découpler l'enveloppe de la deuxième entrée du comparateur (65) en réponse à la désactivation du signal MIL.

4. Dispositif selon la revendication 3, dans lequel le circuit démodulateur récepteur (23) comprend en outre :
un premier filtre (60) couplé entre une première borne (P0) de la bobine primaire et une première entrée du détecteur d'enveloppe (62) ; et
un deuxième filtre (61) couplé entre une deuxième borne (P1) de la bobine primaire et une deuxième entrée du détecteur d'enveloppe (62).

5. Dispositif selon la revendication 4, dans lequel le circuit démodulateur récepteur (23) comprend en outre un troisième filtre (63) couplé entre le détecteur d'enveloppe (62) et la première entrée du comparateur (65).

6. Dispositif selon la revendication 5, dans lequel le circuit démodulateur récepteur (23) comprend en outre une résistance (R3) couplée entre l'interrupteur (S2) et la deuxième entrée du comparateur (65).

7. Dispositif selon la revendication 6, dans lequel le circuit de logique combinatoire comprend :
un circuit de retard (66) configuré pour retarder la sortie du comparateur (65) ;
un inverseur (67) configuré pour inverser la sortie du comparateur (65) ; et
une porte NON-ET (68) configurée pour réaliser une opération de NON-ET logique sur la sortie retardée du comparateur (65) et la sortie inversée du comparateur (65) pour produire ainsi le signal de réinitialisation (RST).

8. Dispositif selon la revendication 1, dans lequel le circuit de commande côté secondaire (40) comprend :
un redresseur (41) configuré pour redresser l'énergie reçue au secondaire pour produire une tension de sortie (VOUT) sur un nœud de sortie (Nout) ;
un diviseur à résistances (Rr1, Rr2) couplé entre le nœud de sortie (Nout) et la masse, la tension de rétroaction (VFBK) étant générée sur un point de dérivation du diviseur à résistances,
un comparateur (42) configuré pour activer un signal de rétroaction intermédiaire (FB) si la tension de rétroaction (VFBK) est supérieure ou égale à la tension de référence (VREF) ;
un pilote (43) configuré pour activer un signal de commande (MOD) en réponse à l'activation du signal de rétroaction intermédiaire (FB) ; et
un interrupteur (S1) configuré pour connecter ladite capacité (C) entre la bobine secondaire et la masse en réponse à l'activation du signal de commande (MOD) pour moduler ainsi et envoyer le signal de rétroaction ASK du secondaire au primaire.

9. Dispositif selon la revendication 1, dans lequel le convertisseur continu-continu (10) est configuré pour être employé pour alimenter un pilote de grille (201) qui produit un signal de pilotage de grille pour une grille d'un transistor de puissance (M) qui alimente une charge (202).
